# DEMANDE DE BREVET EUROPEEN

(11) **EP 2 782 145 A1**
(43) Date de publication de la demande: **24.09.2014**
(21) Numéro de dépôt: 13305344.7
(22) Date de dépôt: 21.03.2013
(51) Int. Cl.: H01L 31/0687, H01L 31/18

(54) **Procédé de fabrication d'un dispositif photovoltaïque multi-jonctions et dispositif photovoltaïque multi-jonctions ainsi obtenu**

(71) Demandeur: ALCATEL LUCENT, 92100 Boulogne-Billancourt (FR); Commissariat à l'Énergie Atomique et aux Énergies Alternatives, 75015 Paris (FR); Ecole Polytechnique, 91120 Palaiseau (FR); Thales, 92200 Neuilly Sur Seine (FR)
(72) Inventeur: Gentner, Jean-Louis, 91460 Marcoussis (FR); Cariou, Romain, 91620 Nozay (FR); Roca I Cabarrocas, Pere, 91140 Villebon sur Yvette (ES)
(74) Mandataire: Loyer & Abello

(57) **Abrégé**

L'invention concerne un procédé de fabrication d'un dispositif photovoltaïque multi-jonctions comportant un empilement d'au moins deux cellules élémentaires (4, 5) à jonction P-N fabriquées à partir de matériaux semiconducteurs présentant des largeurs de bande interdite différentes correspondant à l'énergie d'un photon à des longueurs d'ondes respectives du rayonnement solaire, lesdits cellules élémentaires (4, 5) étant agencées, dans le sens décroissant de la profondeur, par largeurs de bande interdite croissantes, ledit procédé comportant les étapes suivantes :
- fabriquer une cellule élémentaire supérieure (4) à partir d'un matériau semiconducteur III-V ; et
- fabriquer une cellule élémentaire inférieure (5) à partir d'un matériau semiconducteur choisi parmi les matériaux du groupe IV et leurs alliages *tels que* le silicium, le germanium et les alliages de silicium germanium, la cellule élémentaire inférieure (5) présentant une largeur de bande interdite inférieure à la largeur de bande interdite de la cellule élémentaire supérieure (4) ;

la fabrication de la cellule élémentaire inférieure (5) comportant une étape d'hétéro-épitaxie de la cellule élémentaire inférieure (5) lors de laquelle on dépose la cellule élémentaire inférieure (5) sur la cellule élémentaire supérieure (4) par dépôt chimique en phase vapeur assisté par plasma. Le procédé de fabrication comporte une étape de séparation des cellules élémentaires de leur substrat de croissance cristallin.

## Description

### Domaine technique

L'invention se rapporte au domaine des dispositifs photovoltaïques.

L'invention concerne plus particulièrement un dispositif photovoltaïque multi-jonctions et un procédé de fabrication d'un tel dispositif photovoltaïque multi-jonctions.

### Arrière-plan technologique

Un dispositif photovoltaïque est un dispositif permettant d'absorber de l'énergie lumineuse et de la convertir en énergie électrique. Un tel dispositif se compose de matériaux semi-conducteurs dopés P (c'est-à-dire présentant un déficit d'électrons, c'est-à-dire des trous de charges) et de matériaux semi-conducteurs dopés N (c'est-à-dire présentant un excès d'électrons) réunis au niveau d'une jonction dite « jonction P-N ». Lorsque le dispositif est exposé à la lumière, un photon d'énergie suffisante arrache un électron créant au passage un trou et une différence de potentiel de part et d'autre de la jonction P-N.

Jusqu'à récemment, la plupart des cellules photovoltaïques ont été fabriquées à partir de silicium, plus précisément de silicium dopé par des atomes tels que du phosphore, de l'arsenic ou de l'antimoine pour constituer la zone N et de silicium dopé par des atomes tels que du bore pour constituer la zone P de la cellule. Toutefois, les rendements de conversion de l'énergie lumineuse en énergie électrique de cellules photovoltaïques en silicium s'avèrent limités, le rendement record étant de 25 %.

Afin d'obtenir de meilleurs rendements de conversion énergétique, des dispositifs photovoltaïques multi-jonctions ont été développés. Le principe des dispositifs photovoltaïques multi-jonctions est d'empiler en couches successives une pluralité de cellules élémentaires à jonction P-N qui sont chacune optimisées pour la conversion d'une portion du spectre solaire. Par exemple, pour un dispositif photovoltaïque comportant un empilement de trois jonctions, la jonction P-N supérieure est réalisée dans un matériau semi-conducteur présentant une largeur de bande interdite (« band gap » en anglais) élevée et agit ainsi comme un filtre passe-bas en récupérant les photons de plus grande énergie, tels que les photons de l'ultra-violet et d'une partie du spectre visible, la jonction P-N intermédiaire est réalisée dans un matériau semi-conducteur présentant une largeur de bande interdite intermédiaire et exploite ainsi les photons du spectre visible restant tandis la jonction P-N inférieure qui est réalisée dans un matériau semi-conducteur à faible largeur de bande interdite exploite le reste des photons (infra-rouge).

Pour réaliser de tels dispositifs photovoltaïques multi-jonctions, l'association d'une ou plusieurs jonctions P-N fabriquées dans un matériau semi-conducteur du groupe IV à faible largeur de bande interdite tel que le silicium, le germanium ou un alliage des deux, avec une ou plusieurs jonctions P-N en matériau semi-conducteur III-V à largeur de bande interdite plus importante semble particulièrement prometteuse, notamment en ce qu'elle permet un bon recouvrement du spectre solaire et permet ainsi d'obtenir de bons rendements de conversion ; et cela pour des coûts de production limités.

On connaît un procédé de fabrication de tels dispositifs multi-jonctions consistant à réaliser des dispositifs tandems associant une jonction P-N en matériau semi-conducteur III-V et une jonction P-N en silicium en déposant par épitaxie par jet moléculaire de l'arséniure de gallium sur un substrat en silicium.

Toutefois, les matériaux semi-conducteurs III-V tels que l'arséniure de gallium ont un désaccord de réseau cristallin par rapport au silicium. En outre, les coefficients de dilatation thermique des matériaux semi-conducteurs III-V et du silicium sont relativement différents et engendrent des contraintes mécaniques à l'interface entre les cellules élémentaires d'arséniure de gallium et de silicium. Aussi, la structure de la cellule élémentaire d'arséniure de gallium présente une densité importante de dislocations ou défauts cristallins, à l'interface avec la cellule de silicium, ce qui nuit au rendement de conversion du dispositif photovoltaïque ainsi réalisé.

### Résumé

Une idée à la base de l'invention est de proposer un procédé de fabrication d'un dispositif photovoltaïque multi-jonctions, ainsi qu'un dispositif photovoltaïque multi-jonctions obtenu par un tel procédé, associant des matériaux semi-conducteurs du groupe IV (C, Si, Ge, Sn, Pb) ou leurs alliages, et des matériaux semi-conducteur III-V et permettant d'obtenir un rendement de conversion de l'énergie lumineuse en énergie électrique accru.

Selon un mode de réalisation, l'invention propose un procédé de fabrication d'un dispositif photovoltaïque multi-jonctions comportant un empilement d'au moins deux cellules élémentaires à jonction P-N fabriquées à partir de matériaux semi-conducteurs présentant des largeurs de bande interdite différentes correspondant à l'énergie d'un photon à des longueurs d'ondes respectives du rayonnement solaire, lesdites cellules élémentaires étant agencées, dans le sens décroissant de la profondeur, par largeurs de bande interdite croissantes, ledit procédé comportant les étapes suivantes :
- fabriquer une cellule élémentaire supérieure à partir d'un matériau semi-conducteur III-V ; et
- fabriquer une cellule élémentaire inférieure à partir d'un matériau semi-conducteur choisi parmi les matériaux du groupe IV et leurs alliages tels que le silicium, le germanium et les alliages de silicium germanium, la cellule élémentaire inférieure présentant une largeur de bande interdite inférieure à la largeur de bande interdite de la cellule élémentaire supérieure,
la fabrication de la cellule élémentaire inférieure comportant une étape d'hétéro-épitaxie de la cellule élémentaire inférieure lors de laquelle on dépose la cellule élémentaire inférieure sur la cellule élémentaire supérieure par dépôt chimique en phase vapeur assisté par plasma.

Ainsi, la cellule élémentaire inférieure est réalisée par un procédé de dépôt assisté par plasma permettant de déposer des semi-conducteurs à basse température de telle sorte que les conséquences, sur la qualité des structures cristallines, des différences de coefficient de dilatation thermique entre les semi-conducteurs du groupe IV et leurs alliages (Si, Ge, SiGe) et les semi-conducteurs III-V sont limitées. De plus, l'utilisation de basses températures limite la diffusion des impuretés dopantes dans la cellule élémentaire supérieure lors du dépôt de la cellule élémentaire inférieure.

En outre, un tel procédé de dépôt assisté par plasma utilise un mélange gazeux comprenant de l'hydrogène et éventuellement des hydrures qui contribuent à la passivation et à la neutralisation des défauts cristallins à l'interface entre la cellule élémentaire inférieure et la cellule élémentaire supérieure.

De plus, l'approche « inversée » du procédé de fabrication dans lequel les cellules inférieures sont déposées sur les cellules supérieures permet d'épargner la qualité cristalline des cellules supérieures à plus forte largeur de bande interdite.

Enfin, le dépôt de semi-conducteurs du groupe IV ou de leurs alliages assisté par plasma est relativement peu coûteux et compatible avec les exigences industrielles de production série de telle sorte que le procédé de fabrication permet d'obtenir une réduction significative des coûts de production de dispositifs photovoltaïques multi-jonctions performants.

Selon des modes de réalisation, un tel procédé de fabrication peut comporter une ou plusieurs des caractéristiques suivantes :
- lors de l'étape d'hétéro-épitaxie de la cellule élémentaire inférieure sur la cellule élémentaire supérieure, le plasma est généré par radiofréquences et la température de dépôt de la cellule élémentaire inférieure est inférieure à 350 °C, et de préférence comprise entre 100 et 250 °C. En d'autres termes, le dépôt est réalisé par un procédé basse température.
- la fabrication de la cellule élémentaire supérieure comporte une étape d'épitaxie de la cellule élémentaire supérieure sur un substrat par dépôt chimique en phase vapeur utilisant des précurseurs métallo-organiques ou par épitaxie par jets moléculaires.
- une jonction tunnel peut être formée à l'interface entre lesdites cellules élémentaires supérieure et inférieure.
- lors de l'étape d'hétéro-épitaxie de la cellule élémentaire inférieure sur la cellule élémentaire supérieure et/ou lors de l'étape d'épitaxie de la cellule élémentaire supérieure sur un substrat, une jonction tunnel peut être formée dans la cellule élémentaire inférieure et/ou dans la cellule élémentaire supérieure, à l'interface entre lesdites cellules élémentaires, inférieure et supérieure.
- le substrat est un substrat cristallin en matériau semi-conducteur choisi parmi les matériaux de type III-V, tel que l'arséniure de gallium AsGa ou le phosphure d'indium InP, et les matériaux du groupe IV et leurs alliages, tel que le germanium Ge.
- le procédé comporte une étape de fabrication d'une couche de séparation entre la cellule élémentaire supérieure et son substrat et une étape de séparation de la cellule élémentaire supérieure de son substrat. Ainsi, le substrat peut être ultérieurement réutilisé pour la fabrication d'autres dispositifs photovoltaïques.
- la couche de séparation en arséniure de gallium aluminium peut être fabriquée par dépôt chimique en phase vapeur utilisant des précurseurs métallo-organiques ou par épitaxie par jets moléculaires.
- le procédé comporte une étape de séparation de la cellule élémentaire supérieure de son substrat qui est réalisée par élimination de la couche de séparation, par exemple par gravure chimique à l'acide fluorhydrique de la couche de séparation.
- préalablement à l'étape d'hétéro-épitaxie de la cellule élémentaire inférieure, le procédé comporte une opération de nettoyage superficiel de la cellule élémentaire supérieure de préférence in situ par voie plasma. Cette opération permet d'obtenir une surface de base de bonne qualité cristallographique pour la croissance de la cellule élémentaire inférieure et cela, dans le même réacteur que celui permettant un dépôt chimique en phase vapeur assisté par plasma.
- après séparation de la cellule élémentaire supérieure de son substrat, l'empilement de couches successives est reporté, sous forme de film, sur un support fabriqué dans un matériau choisi parmi les métaux, le verre, le plastique et les matériaux souples. Un tel film présente typiquement une épaisseur inférieure à 30 µm, de préférence comprise entre 10 et 20 µm.

Selon un mode de réalisation, l'invention fournit également un dispositif photovoltaïque multi-jonctions comportant un empilement d'au moins deux cellules élémentaires à jonction P-N fabriquées à partir de matériaux semi-conducteurs présentant des largeurs de bande interdite différentes correspondant à l'énergie d'un photon à des longueurs d'ondes respectives du rayonnement solaire, lesdites cellules élémentaires étant agencées, dans le sens décroissant de la profondeur, par largeurs de bande interdite croissantes, l'empilement comportant :
- une cellule élémentaire inférieure fabriquée à partir d'un matériau semi-conducteur choisi parmi les matériaux du groupe IV et leur alliages ; et
- une cellule élémentaire supérieure fabriquée à partir d'un matériau choisi parmi les matériaux semi-conducteurs III-V,
dans lequel la cellule élémentaire inférieure est obtenue par hétéro-épitaxie de la cellule élémentaire inférieure sur la cellule élémentaire supérieure par dépôt chimique en phase vapeur assisté par plasma.

Un tel dispositif photovoltaïque se distingue notamment d'un dispositif photovoltaïque dans lequel la cellule élémentaire supérieure en semi-conducteur III-V aurait été déposée sur une cellule élémentaire inférieure en semi-conducteur élémentaire en ce que la densité de défauts cristallins est plus importante dans la cellule élémentaire inférieure que dans la couche supérieure.

D'autre part, le dépôt de la cellule élémentaire inférieure par un procédé à basse température permet d'obtenir une densité de défauts cristallins à l'interface entre les cellules élémentaires, supérieure et inférieure, qui est globalement plus faible qu'avec d'autres procédés.

Selon des modes de réalisation, un tel dispositif photovoltaïque multi-jonctions peut comporter une ou plusieurs des caractéristiques suivantes :
- la cellule élémentaire inférieure est fabriquée dans un alliage de silicium germanium de type Si₁₋ₓGeₓ.
- le dispositif comporte une pluralité de cellules élémentaires inférieures présentant des largeurs de bande interdite différentes, la pluralité de cellules élémentaires inférieures comprenant au moins deux matériaux choisis parmi les matériaux du groupe IV et leurs alliages, tels que le silicium, le germanium et les alliages de type Si₁₋ₓGeₓ.
- le dispositif comporte une pluralité de cellules élémentaires supérieures présentant des largeurs de bande interdite différentes, la pluralité de cellules élémentaires supérieures comprenant au moins deux matériaux choisis parmi les matériaux semiconducteurs de type III-V, tels que les arséniures de gallium-aluminium (Al_{y}Ga_{1-y}As), les phosphures de gallium-indium (Ga_{z}In_{1-z}P), les arséniures-phosphures de gallium-indium (InGaAsP), et les phosphures de gallium-indium-aluminium (AlGalnP).
- une cellule élémentaire inférieure présente une épaisseur inférieure ou égale à 20 µm.
- la densité de dislocations dans une cellule élémentaire inférieure au niveau d'une interface avec une cellule élémentaire supérieure est inférieure ou égale à 10⁷ cm⁻².
- la densité volumique d'atomes d'hydrogène dans une cellule élémentaire inférieure est comprise entre 0.01% et 2% de la densité volumique d'atomes de la matrice cristalline, et de préférence entre 0.01% et 1%. Une telle concentration est caractéristique d'un dépôt chimique en phase vapeur assisté par plasma.

Un mode de réalisation de l'invention concerne également un ensemble photovoltaïque comportant une pluralité de dispositifs photovoltaïques tels que mentionnés ci-dessus. Dans un mode de réalisation, l'ensemble photovoltaïque comporte un dispositif de concentration du rayonnement solaire. Dans un mode de réalisation, le dispositif de concentration du rayonnement solaire est fixe et ne comporte donc pas d'élément mobile de suivi de la position du soleil.

Enfin, un mode de réalisation de l'invention concerne également l'utilisation d'un ensemble photovoltaïque pour l'alimentation électrique d'une station de base d'un réseau de télécommunication cellulaire ou pour la fabrication d'une ferme solaire.

### Brève description des figures

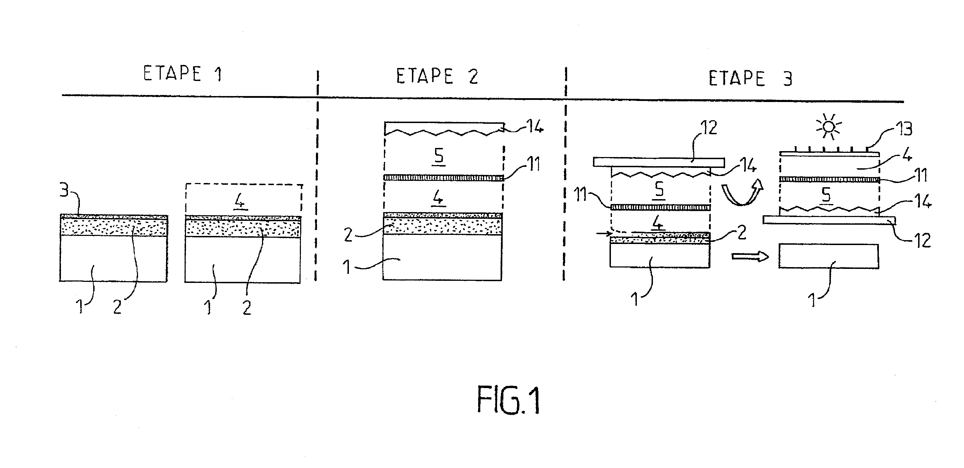

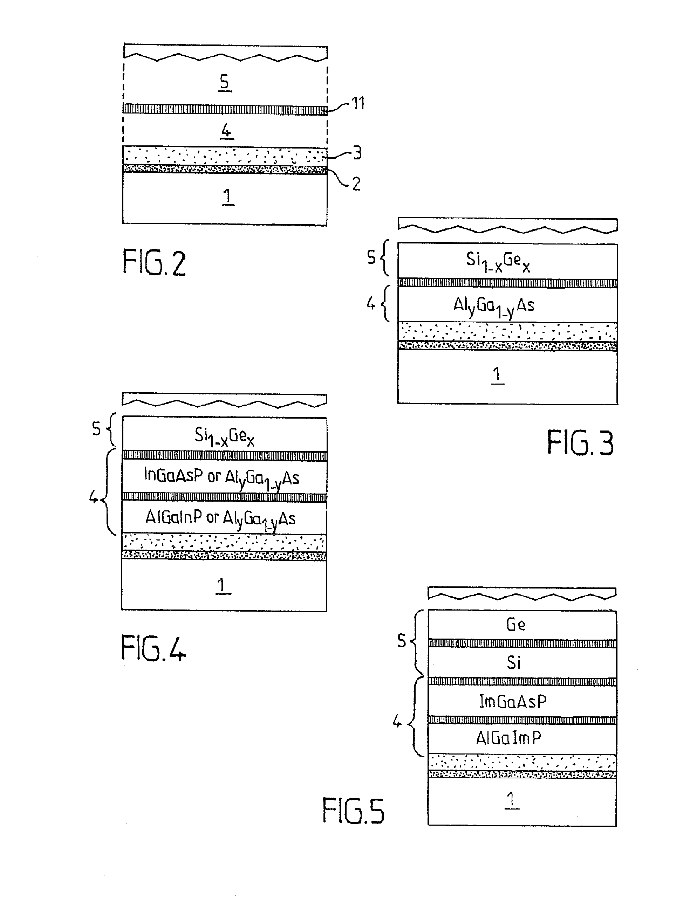

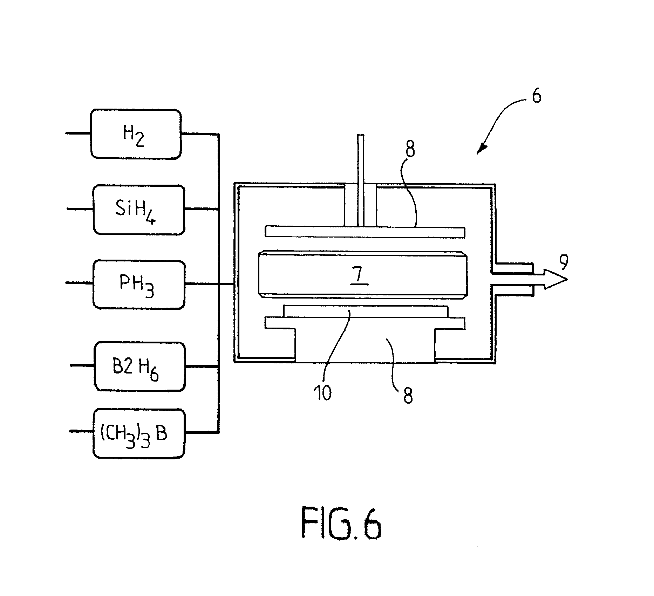

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.
- **La** **figure 1** illustre différentes étapes successives d'un procédé de fabrication d'un dispositif photovoltaïque multi-jonctions.
- **La** **figure 2** illustre un empilement de deux cellules élémentaires à jonction P-N.
- **La** **figure 3** illustre un empilement de deux cellules élémentaires à jonction P-N selon un mode de réalisation.
- **La** **figure 4** illustre un empilement de trois cellules élémentaires à jonction P-N selon un mode de réalisation.
- **La** **figure 5** illustre un empilement de quatre cellules élémentaires à jonction P-N selon un mode de réalisation.
- **La** **figure 6** illustre un réacteur de dépôt chimique en phase vapeur assisté par plasma

### Description détaillée de modes de réalisation

En référence à la figure 1, un procédé de fabrication d'un dispositif photovoltaïque multi-jonctions est décrit.

Notons que le procédé de fabrication qui sera décrit par la suite utilise une approche dite « inversée ». En effet, lors de la fabrication des cellules élémentaires, l'on empile successivement du bas vers le haut, la (les) cellule(s) supérieure(s) présentant une largeur de bande interdite la plus importante puis la (les) cellule (s) inférieure(s) présentant une plus faible largeur de bande interdite. En d'autres termes, la cellule supérieure, la plus proche de la source lumineuse à convertir, lorsque le dispositif photovoltaïque est en fonctionnement, se situe en bas de la pile lors de la fabrication tandis que la cellule inférieure, la plus profonde et la plus éloignée de la source lumineuse, se situe en haut de la pile lors de la fabrication.

Dans une première étape (ETAPE 1), un substrat cristallin 1 est placé dans un réacteur adapté au dépôt par épitaxie d'une ou plusieurs cellules élémentaires supérieures 4 de semi-conducteurs III-V à jonction P-N. Le substrat cristallin 1 est de préférence structurellement compatible pour une croissance épitaxiale de la (des) cellule(s) élémentaire(s) supérieure(s) 4 de semi-conducteurs III-V. Pour ce faire, la nature du substrat cristallin 1 est déterminée en fonction des paramètres du matériau semi-conducteur III-V à déposer, et notamment de ses paramètres cristallins. Le substrat cristallin 1 peut notamment être un substrat d'arséniure de gallium (GaAs).

Dans un mode de réalisation, une couche tampon 2 est formée sur le substrat 1. Une telle couche tampon 2, communément appelée « buffer », est formée entre le substrat 1 et la cellule élémentaire supérieure 4. Elle permet notamment de faire une transition entre différentes structures cristallographiques et/ou permet d'avoir un matériau de base de bonne qualité cristallographique, nécessaire à la croissance épitaxiale des autres couches. Une telle couche tampon 2 présente, par exemple, une épaisseur de l'ordre de 200 nm et est réalisée dans un matériau semi-conducteur III-V, tel que l'arséniure de gallium, par exemple.

En outre, une couche de séparation 3 est formée sur le substrat cristallin 1, ou sur la couche tampon 2 lorsqu'une telle couche tampon 2 existe. La couche de séparation 3 comporte, par exemple, de l'arséniure de gallium aluminium (GaAlAs). L'alliage d'arséniure de gallium est par exemple un alliage du type Al_{y}Ga_{1-y}As dans lequel la proportion molaire d'aluminium y dans l'alliage d'arséniure de gallium-aluminium est supérieure à 0.7. L'épaisseur de la couche de séparation 3 est typiquement de l'ordre de 10 à 100 nm. Une telle couche de séparation permet de séparer les couches de semi-conducteur, formées au-dessus de la couche de séparation 3, du substrat cristallin 1 afin de permettre une réutilisation dudit substrat cristallin 1.

De manière alternative, dans un mode de réalisation non représenté, il est également possible de réaliser une couche de séparation 3 par implantation d'ions H⁺ ou He⁺ dans une couche tampon entre le substrat cristallin 1 et la cellule élémentaire supérieure 4. Une telle implantation d'ions H⁺ ou He⁺ permet de fragiliser le matériau et de former ainsi une zone de séparation préférentielle, la séparation pouvant s'effectuer par exemple par clivage mécanique.

Par la suite, une ou plusieurs cellules élémentaires supérieures 4 à jonction P-N fabriquées dans un matériau semi-conducteur III-V sont déposées par épitaxie. Un semi-conducteur III-V est un semi-conducteur composite fabriqué à partir d'un ou plusieurs éléments de la colonne III du tableau périodique des éléments (bore, aluminium, gallium, indium ou autres), et d'un ou plusieurs éléments de la colonne V (azote, phosphore, arsenic, antimoine ou autres).

A titre d'exemple, les matériaux semi-conducteurs III-V sont choisis parmi les arséniures de gallium-aluminium (Al_{y}Ga_{1-y}As), les phosphures de gallium-indium (Ga_{z}In_{1-z}P), les arséniures-phosphures de gallium-indium (InGaAsP) et les phosphures de gallium-indium-aluminium (AlGalnP).

Le(s) matériau(x) semi-conducteur(s) III-V de la (des) cellule(s) élémentaire(s) supérieure(s) 4 à jonction P-N est déposé sur le substrat cristallin 1 par toute méthode appropriée tel que le dépôt chimique en phase vapeur utilisant des précurseurs métallo-organique (MOCVD pour « Metalorganic Chemical Vapor Deposition » en langue anglaise) ou l'épitaxie par jets moléculaires (MBE pour « Molecular Beam Epitaxy »). La (les) cellule(s) élémentaire(s) supérieure(s) 4 ainsi obtenue(s) est cristalline et, de préférence, monocristalline.

Chaque cellule élémentaire supérieure 4 à jonction P-N comporte une portion d'épaisseur qui est dopée P et une portion d'épaisseur qui est dopée N de sorte à former une jonction P-N. Pour ce faire, des impuretés dopantes de type P et des impuretés dopantes de type N sont introduites dans le matériau semi-conducteur intrinsèque pendant la croissance dudit matériau semi-conducteur ou après celle-ci par diffusion ou par implantation ionique, par exemple.

Lorsque plusieurs cellules élémentaires 4 fabriquées dans des matériaux semi-conducteurs III-V sont empilées, les cellules élémentaires 4 sont successivement déposées par largeurs de bande interdite décroissantes. Par ailleurs, à l'interface entre deux cellules élémentaires 4, une jonction tunnel est formée dans l'une et/ou l'autre des deux cellules élémentaires 4 adjacentes. Une telle jonction tunnel est constituée de deux couches de matériau semi-conducteur fortement dopées P et N pour être électriquement conductrices. Une jonction tunnel permet une mise en série électrique des jonctions P-N. Lorsque les jonctions P-N principales des cellules élémentaires supérieures 4 sont du type N sur P, les jonctions tunnels sont du type P sur N et, inversement, lorsque les jonctions P-N principales des cellules élémentaires supérieures 4 sont du type P sur N, les jonctions tunnels sont du type N sur P.

L'épaisseur d'une cellule élémentaire supérieure 4 à jonction P-N en semi-conducteurs III-V est typiquement de l'ordre de 0.5 à 10 µm.

Par la suite, dans une seconde étape (ETAPE 2), l'empilement comprenant le substrat cristallin 1 et la(les) cellule (s) élémentaire(s) supérieure(s) 4 de semi-conducteurs III-V est introduit dans un second réacteur pour procéder au dépôt d'une ou plusieurs cellules élémentaires inférieures 5, fabriquées dans un matériau semi-conducteur élémentaire choisi parmi le silicium Si, le germanium Ge et les alliages de silicium germanium SiGe ou Si₁₋ₓGeₓ, sur la (les) cellule(s) élémentaire(s) supérieure(s) 4.

La (es) cellule (s) élémentaire(s) inférieure(s) 5 est déposée par hétéro-épitaxie au moyen d'un dépôt chimique en phase vapeur assisté par plasma, communément appelé PECVD pour « Plasma-enhanced Chemical Vapor Deposition ». La (les) cellule (s) élémentaire(s) inférieure(s) 5 ainsi obtenue est cristalline et, de préférence, monocristalline.

Un réacteur 6 permettant la mise en oeuvre d'un tel procédé de dépôt chimique en phase vapeur assistée par plasma est illustré schématiquement sur la figure 6. Un plasma 7 permettant d'ioniser les espèces présentes dans le réacteur 6 est créé en apportant de l'énergie au système. Le plasma 7 est ici créé en appliquant un courant alternatif radio fréquence entre deux électrodes 8. La fréquence du courant appliqué est inférieure ou égale à 100 MHz, typiquement de l'ordre de 13,56 Mhz. L'excitation RF peut être de type sinusoïdale ou plus complexe. Le réacteur est maintenu par une pompe 9 à des pressions de l'ordre de centaines de milli torrs à quelques torrs. Le plasma provoque la création d'ions, de radicaux et d'agrégats qui contribuent à la croissance d'une couche de matériau sur la surface d'un substrat 10 exposé au plasma.

Pour la fabrication d'une cellule élémentaire inférieure 5, les gaz réactifs injectés dans le réacteur 6 sont typiquement un mélange gazeux de dihydrogène H₂, et d'un ou plusieurs gaz précurseurs. Pour le dépôt de silicium, le(s) gaz précurseur(s) est choisi parmi SiH₄, Si₂H₆, SiF₄, SiCl₃H, SiCl₂H₂ et autres gaz apparentés. Pour le dépôt de germanium, le gaz précurseur pourra notamment être GeH₄, GeCl₄ ou GeF₄. Enfin, pour le dépôt d'une cellule élémentaire inférieure 5 d'un alliage silicium-germanium, les gaz précurseurs sont des hydrures et/ou fluorures de silicium et de germanium.

Une telle méthode de dépôt chimique assisté par plasma permet de déposer des couches de semi-conducteur à basse température. Ainsi, lors du dépôt, la température de dépôt ou température de la cellule élémentaire supérieure 4 sur laquelle est déposée le silicium, le germanium ou le silicium-germanium est inférieure à 350 °C, et de préférence comprise entre 100 et 250°C.

Les zones de cellule élémentaire inférieure 5 sont dopées N ou P en ajoutant au mélange gazeux de la phosphine PH₃ (dopage N), du diborane B₂H₆ ou du trimethylborane (CH₃)₃B (dopage P).

L'épaisseur d'une cellule élémentaire inférieure 5 à jonction P-N en silicium, germanium ou silicium-germanium est avantageusement inférieure à 20 µm, typiquement de l'ordre de 10 µm.

Dans un mode de réalisation, la surface de la cellule élémentaire supérieure 4 sur laquelle va être déposée la cellule élémentaire inférieure 5 subit une opération de nettoyage ou de passivation. Pour ce faire, la surface peut être exposée à un plasma radiofréquence généré à partir d'un gaz fluoré, de type SiF₄ ou SiF₆. De manière alternative, l'opération de nettoyage peut être réalisée par voie humide avec une solution standard d'acide fluorhydrique.

Dans un mode de réalisation, une couche tampon ou « buffer » est implantée entre la (les) cellule(s) élémentaire(s) supérieure(s) 4 en semi-conducteur III-V et la (les) cellule(s) élémentaire(s) inférieure(s) 5 en silicium, germanium ou silicium-germanium. Une telle couche tampon permet de faire la transition entre la structure cristallographique des semi-conducteur III-V et la structure cristallographique des semi-conducteurs élémentaires tels que le silicium, le germanium ou le silicium-germanium. La couche tampon présente, par exemple, une épaisseur de l'ordre de 10 à 500 nm.

Un tel procédé de dépôt permet d'obtenir une densité de dislocation dans la cellule élémentaire inférieure 5 qui est inférieure à 10⁷ cm⁻².

Afin de mettre électriquement en série, la cellule élémentaire supérieure 4 et la cellule élémentaire inférieure 5, une jonction tunnel 11 est prévue à l'interface entre ces deux cellules élémentaires 4, 5. Pour ce faire, deux couches fortement dopées N et P sont prévues dans l'une et/ou l'autre de ces cellules 4, 5 à l'interface entre celles-ci. Aussi, une telle jonction tunnel 11 peut être fabriquée lors de la fabrication de la cellule élémentaire inférieure 5 et/ou lors de la fabrication de la cellule élémentaire supérieure 4.

Dans un mode de réalisation, la jonction tunnel 11 est réalisée dans le matériau en semi-conducteur III-V de la cellule élémentaire supérieure 4. Dans ce cas, afin d'éviter la diffusion d'hydrogène dans la couche fortement dopée P de la jonction tunnel 11 lors du dépôt de la cellule élémentaire inférieure 5, la couche fortement dopée N de la jonction tunnel 11 est déposée sur la couche fortement dopée P. En d'autres termes, le procédé utilisant une approche dite inversée, la jonction tunnel sera de préférence, dans ce cas, une jonction P sur N et les cellules élémentaires supérieures 4 et inférieure 5 sont des jonctions N sur P.

Dans un autre mode de réalisation, la jonction tunnel 11 est réalisée dans le matériau en semi-conducteur élémentaire de la cellule élémentaire inférieure 5.

Dans un mode de réalisation alternatif, il est possible de réaliser la couche fortement dopée N dans le matériau en semi-conducteur III-V de la cellule élémentaire supérieure 4 et la couche fortement dopée P, dans le matériau en semi-conducteur de la cellule élémentaire inférieure 5, ou inversement.

Enfin, il est également possible de réaliser une jonction tunnel à l'interface entre la cellule élémentaire supérieure 4 et la cellule élémentaire inférieure 5, dans un matériau semi-conducteur qui ne serait ni celui de la cellule élémentaire supérieure 4 ni celui de la cellule élémentaire inférieure 5.

Comme pour les cellules élémentaires supérieures 4, lorsque le dispositif photovoltaïque comporte plusieurs cellules élémentaires inférieures 5, celles-ci sont successivement déposées par largeurs de bande interdite décroissantes et le dispositif comporte des jonctions tunnel permettant de les mettre en série.

Nous notons en outre que, dans un mode de réalisation, il est possible de se passer de jonction(s) tunnel(s) entre deux cellules élémentaires 4 et/ou 5 superposées, les contacts électriques étant alors pris individuellement pour chacune des cellule(s) élémentaire(s) inférieure(s) 5 et supérieure(s) 4.

Par la suite, un film métallique 14 est déposé sur la cellule élémentaire inférieure 5 pour former une électrode sur la face arrière du dispositif photovoltaïque.

Dans un mode de réalisation, l'on dépose entre la cellule élémentaire inférieure 5 et le film métallique 14 une couche intrinsèque de silicium amorphe hydrogéné et/ou une couche dopée de manière à fournir une passivation de la surface et/ou un champ arrière qui réduit la recombinaison.

Dans un mode réalisation avantageux, l'interface entre la cellule élémentaire inférieure 5 et le film métallique 14 est équipée d'éléments permettant de piéger la lumière à l'intérieur du dispositif photovoltaïque (réflecteurs, pyramides, dispositifs photoniques, plasmoniques ou autres).

Lors de la troisième étape (ETAPE 3), les cellules élémentaires, supérieure 4 et inférieure 5, sont séparées du substrat cristallin 1. Pour ce faire, lorsque la couche de séparation 3 est en arséniure de gallium aluminium (GaAlAs), l'empilement subit une gravure chimique à l'acide fluorhydrique. L'acide fluorhydrique attaque sélectivement la couche de séparation 3 fabriquée en arséniure de gallium aluminium (GaAlAs). Lorsque la couche de séparation 3 est réalisée par implantation d'ions, une opération mécanique de séparation est mise en oeuvre. Ainsi, le substrat cristallin 1 peut être réutilisé pour la fabrication d'autres dispositifs photovoltaïques. Si dans le procédé représenté sur la figure 1, cette opération de séparation est réalisée après la fabrication de la (des) cellule (s) inférieure(s) 5, elle peut également être réalisée avant la fabrication de la cellule inférieure 5.

Après séparation de la cellule élémentaire supérieure 4 de son substrat 1, l'empilement de couches est apte à être reporté, sous forme de film mince, contre un support 12. Un tel film mince présente typiquement une épaisseur inférieure à 30 µm, de préférence comprise entre 10 et 20 µm.

En outre, un empilement de couches successives tel que décrit ci-dessus présente l'avantage de pouvoir être fixé sur des supports souples. Le support 12 peut notamment être fabriqué dans un matériau choisi parmi les métaux, le verre, les plastiques et les matériaux souples. La face arrière du dispositif est collée contre le support 12.

Par ailleurs, et la face avant est équipée d'une grille métallique 13 pour former la seconde électrode du dispositif photovoltaïque.

En outre, dans un mode de réalisation avantageux, la face avant est équipée d'une couche anti-réfléchissante.

Dans un mode de réalisation, un ensemble photovoltaïque comporte une pluralité de dispositifs photovoltaïques multi-jonctions associés avec un dispositif de concentration du rayonnement solaire équipé d'éléments de suivi de la position du soleil. Un tel ensemble présente un rendement de conversion très élevé sous forte concentration. Ce type d'association est particulièrement approprié pour des fermes solaires de grande puissance.

Dans un autre mode de réalisation, le dispositif photovoltaïque est associé avec un dispositif de concentration du rayonnement solaire fixe. En d'autres termes, le dispositif de concentration du rayonnement solaire ne comporte pas d'élément mobile de suivi de la position du soleil. Un tel système permet d'obtenir un rendement de conversion élevé à des concentrations du soleil plus faibles. De tels systèmes sont particulièrement adaptés aux applications de moyenne puissance, telles que les stations de base d'un réseau de télécommunication cellulaire. En outre, une telle association permet d'obtenir un rendement de conversion élevé pour des coûts de fabrication restreints

Les figures 3 à 5 illustrent des empilements de jonction P-N permettant d'obtenir des dispositifs photovoltaïques multi-jonctions présentant des rendements de conversion particulièrement avantageux.

Dans le mode de réalisation de la figure 3, l'empilement ne comporte que deux cellules élémentaires à jonction P-N et est donc destiné à la fabrication d'un dispositif photovoltaïque à double jonctions, également appelé cellule « tandem ».

La cellule élémentaire inférieure 5 est fabriquée dans un alliage de silicium germanium de type Si₁₋ₓGeₓ où x désigne la proportion molaire de germanium dans l'alliage de silicium germanium, tandis que la cellule élémentaire supérieure 4 est fabriquée dans un alliage d'arséniure de gallium-aluminium de type Al_{y}Ga_{1-y}As où y désigne la proportion molaire d'aluminium dans l'alliage d'arséniure de gallium-aluminium. En choisissant x>0.4, la largeur de bande interdite de l'alliage de silicium germanium est de l'ordre de 0.96 eV. En choisissant y>0.17, la largeur de bande interdite de l'alliage d'arséniure de gallium-aluminium est de l'ordre de 1.63 eV. Une telle association d'alliages permet d'obtenir un dispositif photovoltaïque présentant un rendement théorique de 47%.

Le tableau ci-dessous détaille d'autres exemples de dispositifs photovoltaïques tandems susceptibles d'être réalisés conformément au procédé de fabrication décrit ci-dessus.

| **Cellule élémentaire inférieure** | | **Cellule élémentaire supérieure** | | **Rendement théorique** |
|---|---|---|---|---|
| **Matériau semi-conducteur** | **Largeur de bande interdite** | **Matériau semi-conducteur** | **Largeur de bande interdite** | |
| Si | 1.12 eV | Ga_{z}In_{1-z}P avec z> 0.35 | 1.67 eV | 44 % |
| Si | 1.12 eV | Al_{y}Ga_{1-y}As avec y> 0.24 | 1.73 eV | 46 % |

Dans le mode de réalisation de la figure 4, l'empilement comporte une cellule élémentaire inférieure 5 et deux cellules élémentaires supérieures 4. Un dispositif photovoltaïque fabriqué à partir d'un tel empilement est appelé dispositif triple jonctions. La cellule élémentaire inférieure 5 est ici fabriquée dans un alliage silicium germanium de type Si₁₋ₓGeₓ. Dans une variante, la cellule élémentaire supérieure 4 de plus faible largeur de bande interdite est fabriquée dans un alliage d'arséniure-phosphures de gallium-indium (InGaAsP) tandis que la cellule élémentaire supérieure 4 de plus forte largeur de bande interdite est fabriquée dans un alliage d'arséniure de gallium-aluminium de type Al_{y}Ga_{1-y}As. Dans une autre variante, la cellule élémentaire supérieure 4 de plus faible largeur de bande interdite est fabriquée dans un alliage d'arséniure de gallium-aluminium de type Al_{y}Ga_{1-y}As tandis que la cellule élémentaire supérieure 4 de plus forte largeur de bande interdite est fabriquée dans un alliage de phosphure de gallium-indium-aluminium (AlGalnP).

Dans le mode de réalisation de la figure 5, l'empilement comporte deux cellules élémentaires inférieures 5 et deux cellules élémentaires supérieures 4. La cellule élémentaire inférieure 5 de plus faible largeur de bande interdite est ici fabriquée en germanium et la cellule élémentaire inférieure 5 de plus forte largeur de bande interdite est fabriquée en silicium. En outre, la cellule élémentaire supérieure 4 de plus faible largeur de bande interdite est fabriquée dans un alliage d'arséniure-phosphures de gallium-indium (InGaAsP) tandis que la cellule élémentaire supérieure 4 de plus forte largeur de bande interdite est fabriquée dans un alliage de phosphure de gallium-indium-aluminium (AlGalnP).

Le tableau ci-dessous illustre des exemples d'association de largeurs de bande interdite permettant d'obtenir des rendements de conversion particulièrement intéressants pour des dispositifs triple, quadruple ou quintuple jonctions.

| **Largeur de bande interdite N°1** | **Largeur de bande interdite N°2** | **Largeur de bande interdite N°3** | **Largeur de bande interdite N°4** | **Largeur de bande interdite N°5** | **Rendement théorique** |
|---|---|---|---|---|---|
| 1.12 eV (Si) | 1.42 eV (GaAs) | 1.81 eV | - | - | 47% |
| 1.12 eV (Si) | 1.49 eV | 2 eV | - | - | 51.2 % sous une concentration de 100 soleils |
| 0.67 eV (Ge) | 1.2 eV | 1.78 eV | - | - | 53.6 % sous une concentration de 100 soleils |
| 0.67 eV (Ge) | 1.12eV(Si) | 1.49 eV | 2 | - | 57.6 % sous une concentration de 100 soleils |
| 0.7 eV | 1.13 eV | 1.53 eV | 1.93 eV | 2.5 eV | 61.2 % sous une concentration de 100 soleils |

Bien que l'invention ait été décrite en liaison avec plusieurs modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

L'usage du verbe « comporter », « comprendre » ou « inclure » et de ses formes conjuguées n'exclut pas la présence d'autres éléments ou d'autres étapes que ceux énoncés dans une revendication. L'usage de l'article indéfini « un » ou « une » pour un élément ou une étape n'exclut pas, sauf mention contraire, la présence d'une pluralité de tels éléments ou étapes.

Dans les revendications, tout signe de référence entre parenthèses ne saurait être interprété comme une limitation de la revendication.

## Revendications

1. Procédé de fabrication d'un dispositif photovoltaïque multi-jonctions comportant un empilement en couches successives d'au moins deux cellules élémentaires (4, 5) à jonction P-N fabriquées à partir de matériaux semi-conducteurs présentant des largeurs de bande interdite différentes correspondant à l'énergie d'un photon à des longueurs d'ondes respectives du rayonnement solaire, lesdites cellules élémentaires (4, 5) étant agencées, dans le sens décroissant de la profondeur, par largeurs de bande interdite croissantes, ledit procédé comportant les étapes suivantes :
- fabriquer une cellule élémentaire supérieure (4) à partir d'un matériau choisi parmi les matériaux semi-conducteurs III-V; et
- fabriquer une cellule élémentaire inférieure (5) à partir d'un matériau semi-conducteur choisi parmi les matériaux du groupe IV et leurs alliages, la cellule élémentaire inférieure (5) présentant une largeur de bande interdite inférieure à la largeur de bande interdite de la cellule élémentaire supérieure (4) ;
la fabrication de la cellule élémentaire inférieure (5) comportant une étape d'hétéro-épitaxie de la cellule élémentaire inférieure (5) lors de laquelle on dépose la cellule élémentaire inférieure (5) sur la cellule élémentaire supérieure (4) par dépôt chimique en phase vapeur assisté par plasma.

2. Procédé de fabrication selon la revendication 1, dans lequel, lors de l'étape d'hétéro-épitaxie de la cellule élémentaire inférieure (5) sur la cellule élémentaire supérieure (4), le plasma est généré par radiofréquences et la température de dépôt de la cellule élémentaire inférieure (5) est inférieure à 350 °C.

3. Procédé de fabrication selon la revendication 1 ou 2, dans lequel la fabrication de la cellule élémentaire supérieure (4) comporte une étape d'épitaxie de la cellule élémentaire supérieure (4) sur un substrat (1) par dépôt chimique en phase vapeur utilisant des précurseurs métallo-organiques ou par épitaxie par jets moléculaires.

4. Procédé de fabrication selon la revendication 3, dans lequel, lors de l'étape d'hétéro-épitaxie de la cellule élémentaire inférieure (5) sur la cellule élémentaire supérieure (4) et/ou lors de l'étape d'épitaxie de la cellule élémentaire supérieure (4) sur un substrat (1), une jonction tunnel (11) est formée dans la cellule élémentaire inférieure (5) et/ou dans la cellule élémentaire supérieure (4), à l'interface entre lesdites cellules élémentaires inférieure (5) et supérieure (4).

5. Procédé de fabrication selon l'une des revendications 3 et 4, dans lequel le substrat (1) est un substrat cristallin (1) en matériau semi-conducteur choisi parmi les matériaux de type III-V et les matériaux du groupe IV et leurs alliages.

6. Procédé de fabrication selon l'une des revendications 3 à 5, comportant une étape de fabrication d'une couche de séparation (3) entre la cellule élémentaire supérieure (4) et son substrat (1) et une étape de séparation de la cellule élémentaire supérieure (4) de son substrat (1).

7. Procédé de fabrication selon la revendication 6, dans lequel ladite couche de séparation (3) est fabriquée en arséniure de gallium aluminium par dépôt chimique en phase vapeur utilisant des précurseurs métallo-organiques ou par épitaxie par jets molléculaires et dans lequel le procédé comprend une étape de séparation de la cellule élémentaire supérieure (4) de son substrat (1) qui est réalisée par gravure chimique à l'acide fluorhydrique de ladite couche de séparation (3).

8. Procédé de fabrication selon l'une des revendications 6 et 7, dans lequel, après séparation de la cellule élémentaire supérieure (4) de son substrat (1), l'empilement de couches successives est reporté, sous forme de film, sur un support fabriqué dans un matériau choisi parmi les métaux, le verre, les plastiques et les matériaux souples.

9. Procédé de fabrication selon l'une quelconque des revendications 1 à 8, comprenant, préalablement à l'étape d'hétéro-épitaxie de la cellule élémentaire inférieure (5), une opération de nettoyage superficiel de la cellule élémentaire supérieure (4) par voie plasma.

10. Dispositif photovoltaïque multi-jonctions comportant un empilement d'au moins deux cellules élémentaires (4, 5) à jonction P-N fabriquées à partir de matériaux semi-conducteurs présentant des largeurs de bande interdite différentes correspondant à l'énergie d'un photon à des longueurs d'ondes respectives du rayonnement solaire, lesdites cellules élémentaires (4, 5) étant agencées, dans le sens décroissant de la profondeur, par largeurs de bande interdite croissantes, l'empilement comportant :
- une cellule élémentaire inférieure (5) fabriquée à partir d'un matériau semi-conducteur choisi parmi les matériaux du groupe IV et leurs alliages ; et
- une cellule élémentaire supérieure (4) fabriquée à partir d'un matériau choisi parmi les matériaux semi-conducteurs III-V,
dans lequel la cellule élémentaire inférieure (5) est obtenue par hétéro-épitaxie de la cellule élémentaire inférieure (5) sur la cellule élémentaire supérieure (4) par dépôt chimique en phase vapeur assisté par plasma.

11. Dispositif photovoltaïque selon la revendication 10, dans lequel la cellule élémentaire inférieure (5) est fabriquée dans un alliage de silicium germanium de type Si₁₋ₓGeₓ.

12. Dispositif photovoltaïque selon la revendication 10, comportant une pluralité de cellules élémentaires inférieures (5) présentant des largeurs de bande interdite différentes, la pluralité de cellules élémentaires inférieures comprenant au moins deux matériaux choisis parmi le silicium, le germanium et les alliages de type Si₁₋xGeₓ.

13. Dispositif photovoltaïque selon l'une des revendications 10 à 12, comportant une pluralité de cellules élémentaires supérieures (4) présentant des largeurs de bande interdite différentes, la pluralité de cellules élémentaires supérieures comprenant au moins deux matériaux choisis parmi les arséniures de gallium-aluminium (Al_{y}Ga_{1-y}As), les phosphures de gallium-indium (Ga_{z}In_{1-z}P), les arséniures-phosphures de gallium-indium (InGaAsP), et les phosphures de gallium-indium-aluminium (AlGalnP).

14. Dispositif photovoltaïque selon l'une quelconque des revendications 10 à 13, dans lequel une cellule élémentaire inférieure (5) présente une épaisseur inférieure ou égale à 20 µm.

15. Dispositif photovoltaïque selon l'une quelconque des revendications 10 à 14, dans lequel la densité de dislocations dans une cellule élémentaire inférieure (5) au niveau d'une interface avec une cellule élémentaire supérieure (4) est inférieure ou égale à 10⁷ cm⁻².

16. Dispositif photovoltaïque selon l'une des revendications 10 à 15, dans lequel la densité volumique d'atomes d'hydrogène dans une cellule élémentaire inférieure (5) est comprise entre 0.01% et 2% de la densité volumique d'atomes de la matrice cristalline.

17. Ensemble photovoltaïque comportant une pluralité de dispositifs photovoltaïques selon l'une des revendications 10 à 16 et un dispositif de concentration du rayonnement solaire.

18. Ensemble photovoltaïque selon la revendication 17, dans lequel le dispositif de concentration du rayonnement solaire est fixe.

19. Utilisation d'un ensemble photovoltaïque selon l'une des revendications 17 et 18, pour l'alimentation électrique d'une station de base ou pour la fabrication d'une ferme solaire.
